# EUROPÄISCHE PATENTSCHRIFT

(11) **EP 0 774 165 B1**
(45) Veröffentlichungstag und Bekanntmachung des Hinweises auf die Patenterteilung: **21.10.1998**
(21) Anmeldenummer: 95926834.3
(22) Anmeldetag: 01.08.1995
(51) Int. Cl.: H01L 25/065, H01L 21/98, H01L 21/68, H01L 21/78

(54) **VERFAHREN ZUR HERSTELLUNG EINER DREIDIMENSIONALEN SCHALTUNGSANORDNUNG**
METHOD OF MANUFACTURING A THREE-DIMENSIONAL CIRCUIT
PROCEDE DE FABRICATION D'UN CIRCUIT TRIDIMENSIONNEL

(30) Priorität: 03.08.1994 DE 4427515
(43) Veröffentlichungstag der Anmeldung: 21.05.1997
(73) Patentinhaber: SIEMENS AKTIENGESELLSCHAFT, 80333 München (DE)
(72) Erfinder: HÜBNER, Holger, D-85598 Baldham (DE)
(86) Internationale Anmeldenummer: DE9500998
(87) Internationale Veröffentlichungsnummer: WO9604683

(56) Entgegenhaltungen:
- EP-A- 0 531 723
- FR-A- 2 489 041
- US-A- 4 142 893
- JAPANESE JOURNAL OF APPLIED PHYSICS, Bd.23, Nr.10, Oktober 1984, TOKYO Seiten L815 - L817 T. HAMAGUCHI ET AL. 'device layer transfer technique using chemi-mechanical polishing'

## Beschreibung

Bei der kubischen Integration werden dreidimensionale Schaltungsanordnungen als Bauelementstapel realisiert. In einem Bauelementstapel sind vereinzelte Bauelemente übereinander gestapelt und fest miteinander verbunden. Die einzelnen Bauelemente umfassen dabei jeweils integrierte Schaltungen, Sensor-Aktuator-Anordnungen und/oder passive Bauelemente. Die einzelnen Bauelemente können dabei in unterschiedlichen Technologien hergestellt sein. Untereinander sind die verschiedenen Bauelemente durch vertikale Kontakte miteinander elektrisch verbunden.

Bei der Herstellung einer solchen dreidimensionalen Schaltungsanordnung werden zunächst die Bauelemente in üblicher Weise in einem Substrat hergestellt. Zum Zusammenfügen der Bauelementstapel gibt es dann prinzipiell zwei Möglichkeiten: Zum einen können die Bauelemente zunächst alle vereinzelt werden und dann zum Stapel zusammengefügt. Dies erfolgt in der Regel so, daß ein Substrat, das ein dem Stapel hinzuzufügendes weiteres Bauelement umfaßt, mit der Vorderseite auf eine stabile Trägerplatte aufgeklebt wird. Von der Rückseite her wird das Substrat bis auf etwa 10 µm gedünnt. Dann wird das Substrat in die einzelnen Bauelemente vereinzelt. Das vereinzelte Bauelement wird dann auf ein Bauelement oder einen Bauelementstapel aufgesetzt. Das aufgesetzte Bauelement wird mit dem Bauelement oder Bauelementstapel mechanisch und elektrisch verbunden. Der dabei entstandene Bauelementstapel wird von der Trägerplatte abgelöst und in analoger Weise mit weiteren Bauelementen verbunden.

Zum anderen wird das Substrat, das ein einem Stapel hinzuzufügendes Bauelement umfaßt, erst nach der mechanischen Befestigung vereinzelt. Dazu wird das Substrat mit der Vorderseite auf eine Trägerplatte aufgeklebt und von der Rückseite her gedünnt. Anschließend wird das Bauelement oder der Bauelementstapel kopfüber auf das Substrat gesetzt und mit diesem mechanisch und elektrisch verbunden. Erst dann erfolgt die Vereinzelung in einzelne Bauelementstapel.

Die Vereinzelung von Substraten in einzelne Bauelemente erfolgt in der Mikroelektronik durch Zersägen. Bei dem ersten Verfahren erfolgt das Zersägen des Substrats unmittelbar, bevor die Bauelemente aufgesetzt werden. Verunreinigungen, die beim Zersägen des Substrats entstehen, müssen vor der mechanischen Verbindung von der Oberfläche der Bauelemente entfernt werden.

Werden die Bauelemente mit Hilfe eines Klebers untereinander mechanisch verbunden, so wird in der Regel der Kleber vor dem Vereinzeln aufgebracht. Nach der Reinigung von Verunreinigungen, die beim Sägen entstanden sind, muß dann die Oberfläche des Klebers reaktiviert werden.

Ferner muß beim Vereinzeln des Substrats die Trägerplatte auch zerteilt werden. Das Material der Trägerplatte muß daher so gewählt werden, daß es sich mit derselben Säge wie die gedünnte Substratscheibe trennen lassen muß. Darüber hinaus wird in diesem Fall die Trägerplatte beim Hinzufügen jeder Bauelementebene verbraucht.

Bei dem zweiten Verfahren erfolgt die Vereinzelung des Substrats erst nach der mechanischen Verbindung mit dem zu ergänzenden Bauelementstapel. Beim Zerteilen des Substrats muß hier ebenfalls die Trägerplatte zerteilt werden. Das Material für die Trägerplatte muß daher ebenfalls auf das Substratmaterial abgestimmt werden. Da in diesem Fall auf dem Substrat Bauelementstapel angeordnet sind, die jeweils aus gedünnten Ebenen bestehen und sehr bruchanfällig sind, muß vermieden werden, daß die Säge den Rand der Stapel berührt. Es muß daher bei jedem Schritt ein Mindestabstand der Sägekante zur Stapelkante eingehalten werden. Dadurch wird die Platzausnutzung auf dem Substrat und damit die Materialausnutzung des Substrats und der Trägerplatte begrenzt. Auch in diesem Fall muß für jede hinzuzufügende Bauelementebene eine neue Trägerplatte verwendet werden, da diese beim Vereinzeln verteilt wird.

US-A-4 142 893 offenbart ein Verfahren zur Vereinzelung von Substraten in einzelne Bauelemente. Bauelementstapel sind aus EP-A-0 531 723 bekannt.

Der Erfindung liegt das Problem zugrunde, ein weiteres Verfahren zur Herstellung einer dreidimensionalen Schaltungsanordnung anzugeben, bei dem ein Splittern von gedünnten Substratscheiben vermieden wird. Insbesondere soll eine bessere Materialausnutzung von Substrat und Trägerplatte erzielt wird.

Dieses Problem wird erfindungsgemäß gelöst durch ein Verfahren nach Anspruch 1. Weitere Ausgestaltungen der Erfindung gehen aus den übrigen Ansprüchen hervor.

In dem erfindungsgemäßen Verfahren wird eine Substratscheibe, die in einer ersten Hauptfläche Bauelemente umfaßt, mit der ersten Hauptfläche auf eine Trägerplatte aufgeklebt. Die Substratscheibe wird von einer zweiten, der ersten gegenüberliegenden Hauptfläche her gedünnt. Anschließend wird auf der zweiten Hauptfläche eine Photolackmaske erzeugt, die in einem nachfolgenden Ätzprozeß als Ätzmaske verwendet wird. In dem Ätzprozeß wird die Substratscheibe in einzelne Bauelemente vereinzelt. Die Bauelemente sind über die Klebstoffschicht mit der Trägerplatte weiterhin verbunden. Die Photolackmaske wird so erzeugt, daß sie diejenigen Bereiche der Substratscheibe, in denen Bauelemente angeordnet sind, vor dem Ätzangriff schützt. Nach Entfernen der Photolackmaske wird auf mindestens einem der einzelnen Bauelemente mindestens ein weiteres Bauelement angeordnet und mit diesem fest zu einem Bauelementstapel verbunden. Das weitere Bauelement kann dabei selber ein Bauelementstapel sein. Da die Substratscheibe in einem Ätzprozeß vereinzelt wird, wird ein Splittern der Substratscheibe, wie es beim Sägen auftritt, sicher vermieden.

Da in dem erfindungsgemäßen Verfahren beim Vereinzeln der Substratscheibe nur die Substratscheibe selber zerteilt wird, kann das Material für die Trägerplatte frei gewählt werden. Der fertige Bauelementstapel kann anschließend durch Zersägen der Trägerplatte vereinzelt werden.

Gemäß einer anderen, besonders vorteilhaften Ausführungsform wird der Bauelementstapel von der ganzen Trägerplatte abgelöst. Die Trägerplatte wird in diesem Fall nicht verbraucht, so daß auch teurere Materialien wie zum Beispiel Keramik für die Trägerplatte in Frage kommen. Insbesondere liegt es im Rahmen der Erfindung, die Trägerplatte aus einem UV-durchlässigen Material zum Beispiel Quarzglas vorzusehen und zum Ablösen des fertigen Bauelementstapels von der Trägerplatte die Klebstoffschicht durch UV-Bestrahlung durch die Trägerplatte hindurch zu verspröden und damit aufzulösen. Wird der Bauelementstapel mit einem Lösungsmittel abgelöst, so wirkt dieses über die im Ätzprozeß geöffneten Spalten zwischen benachbarten Bauelementstapeln ein.

Das Vereinzeln von integrierte Schaltungen umfassenden Substratscheiben in einem anisotropen Ätzprozeß ist zwar schon in DE 43 08 705 A1 vorgeschlagen worden, um Chips mit einer durch ein Sägeverfahren nicht zu realisierenden, beliebigen Form zu erzeugen. Das Problem des Splittern von gedünnten Substratscheiben und des Materialverbrauchs bei der kubischen Integration ist dort jedoch nicht angesprochen worden.

Da die Substratscheibendicke nach dem Dünnen vorzugsweise 5 µm bis 20 µm beträgt, kann der Ätzprozeß zur Vereinzelung der Substratscheibe sowohl naßchemisch als auch als Plasmaätzprozeß durchgeführt werden. Beim naßchemischen Ätzen kommt es zu einer Unterätzung in der Größenordnung der Substratscheibendicke, die z. B. etwa 10 µm beträgt. Der Abstand zwischen benachbarten Bauelementen in der Substratscheibe muß im Fall des naßchemischen Ätzens entsprechend groß gewählt werden. Übliche Abstände zu den Bauelementen auf einer Substratscheibe in der Siliziumtechnologie betragen 100 µm, so daß die Schichtdicke von 10 µm keine Einschränkung in dieser Hinsicht darstellt. Durch Einsatz eines Plasmaätzprozesses zur Vereinzelung der Substratscheibe kann im Fall einer Siliziumscheibe erhöhte Sauberkeit gewährleistet werden. Dieses geht jedoch auf Kosten der Ätzzeit.

Es liegt im Rahmen der Erfindung, die Photolackmaske durch Aufschleudern einer Photolackschicht auf die zweite Hauptfläche, Belichtung der Photolackschicht mit einer zu den Bauelementen justierten Lithographie und Entwicklung der Photolackschicht zu erzeugen. Die Justierung der Lithographie kann insbesondere auf die sichtbaren Kontaktflächen erfolgen.

Die Verbindung zwischen den Bauelementen im Bauelementstapel kann sowohl mit Hilfe von Klebstoff, zum Beispiel Schmelzkleber oder Polyimid, als auch durch Verlöten von auf den Grenzflächen aufgebrachten Metallflächen erfolgen.

Nach dem Dünnschleifen der Substratscheibe von der zweiten Hauptflache her können zunächst weitere Rückseitenprozesse durchgeführt werden, wie zum Beispiel das Öffnen von Kontaktlöchern von der zweiten Hauptflache her, die auf Verdrahtungsebenen der Bauelemente reichen und über die eine elektrische Kontaktierung zwischen im Stapel benachbarten Bauelementen realisiert wird.

Das Verfahren ist besonders vorteilhaft einsetzbar bei Verwendung von in Halbleitersubstraten realisierten Bauelementen, da bei Halbleitersubstraten eine besonders große Splittergefahr bei der Bearbeitung mit Trennsägen besteht.

Im folgenden wird die Erfindung anhand eines Beispiels und der Figuren näher erläutert.
- Figur 1: zeigt eine Trägerplatte mit einer gedünnten Substratscheibe und einer Photolackmaske.
- Figur 2: zeigt die Substratscheibe nach Vereinzelung in einzelne Bauelemente und dem Aufbringen eines Bauelementstapels.

Eine Substratscheibe 1 aus zum Beispiel monokristallinem Silizium, die im Bereich einer ersten Hauptflache 11 Bauelemente umfaßt, wird mit Hilfe einer Klebstoffschicht 2 auf eine Trägerplatte 3 aufgeklebt. Die Bauelemente, die die Substratscheibe 1 im Bereich der ersten Hauptflache 11 umfaßt und die der Übersichtlichkeit halber nicht im einzelnen dargestellt sind, umfassen integrierte Schaltungen und/oder Sensor- und Aktuatorstrukturen. Die Trägerplatte 3 besteht zum Beispiel aus Quarzglas. Als Klebstoffschicht 2 wird zum Beispiel Schmelzkleber verwendet.

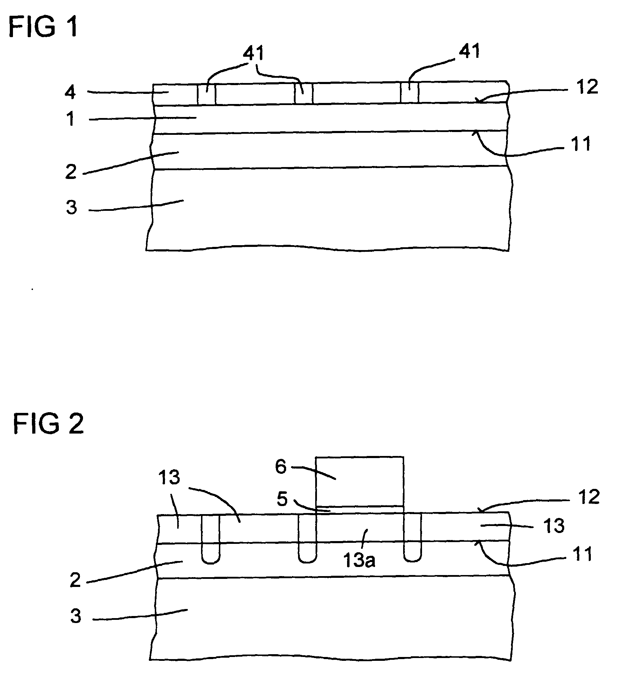

Von einer zweiten Hauptfläche 12, die der ersten Hauptfläche 11 gegenüberliegt, her wird die Substratscheibe 1 zum Beispiel durch Dünnschleifen gedünnt. Senkrecht zur ersten Hauptflache 11 weist die Substratscheibe 1 nach dem Dünnen eine Dicke von 5 bis 20 µm, vorzugsweise 10 µm auf. Auf die zweite Hauptflache 12 wird anschließend eine Photolackmaske 4 aufgebracht (siehe Figur 1).

Die Photolackmaske 4 wird vorzugsweise durch Aufschleudern einer Photolackschicht auf die zweite Hauptflache 12 der Substratscheibe 1, Belichtung der Photolackschicht mit einer zu den Bauelementen justierten Lithographie und Entwicklung der Photolackschicht erzeugt. Die Photolackmaske 4 bedeckt diejenigen Bereiche der zweiten Hauptfläche 12 der Substratscheibe 1, unter denen Bauelemente angeordnet sind. Zwischen benachbarten Bauelementen in der Substratscheibe 1 weist die Photolackmaske 4 Öffnungen 41 auf.

In einem Ätzprozeß, zum Beispiel naßchemisch mit Ätzlösungen auf Chromat-Flußsäure-Basis nach Secco oder Schimmel, wird nun die Substratscheibe 1 in einzelne Bauelemente 13 vereinzelt (siehe Figur 2). Alternativ wird als Ätzprozeß ein Plasmaätzprozeß eingesetzt. Besonders geeignet ist reaktives Ionenätzen (RIE) mit Chlorgas, weil dieser bezüglich Verunreinigungen und Ätzdauer optimiert ist.

In dem Ätzprozeß wird die Substratscheibe 1 vollständig durchtrennt, der Ätzprozeß wird erst unterbrochen, wenn mindestens die Oberfläche der Klebstoffschicht 2 freigelegt ist.

Nach Entfernen der Photolackmaske 4 wird auf mindestens ein Bauelement 13a der Bauelemente 13 eine Haftschicht 5 und darauf ein weiteres Bauelement 6 aufgebracht. Das weitere Bauelement 6 wird über die Haftschicht 5 fest mit dem zuerst genannten Bauelement 13a verbunden. Als Haftschicht 5 ist zum Beispiel eine Polyimidschicht geeignet oder eine Lotmetallschicht, die in einem Lötschritt über auf den Grenzflächen der Bauelemente 13a und 6 aufgebrachten Metallflächen eine feste mechanische Verbindung bildet. Das weitere Bauelement 6 kann als Bauelementstapel aus mehreren untereinander mechanisch und elektrisch verbundenen Bauelementen bestehen. Der aus Bauelement 13a und weiterem Bauelement 6 gebildete Bauelementstapel ist über die Klebstoffschicht 2 nach wie vor fest mit der Trägerplatte 3 verbunden. Durch Lösen der Klebstoffschicht 2 wird der Bauelementstapel 13a, 6 von der Trägerplatte 3 entfernt.

Das Lösen der Klebstoffschicht 2 erfolgt vorzugsweise durch eine rückseitige Bestrahlung mit UV-Licht, bei der die Klebstoffschicht 2 versprödet. Dazu ist es erforderlich, daß die Trägerplatte 3 UV-durchlässig ist.

Alternativ wird die Klebstoffschicht 2 mit Hilfe eines Lösungsmittels, vorzugsweise Azeton, abgelöst.

In der praktischen Durchführung des erfindungsgemäßen Verfahrens ist es vorteilhaft, auf sämtliche funktionsfähige Bauelemente 13 gleichzeitig eine Haftschicht 5 aufzubringen, auf der Bauelemente oder Bauelementstapel 6 angeordnet werden. Nach der mechanischen Verbindung der dabei entstandenen Bauelementstapel werden diese durch Auflösen der Klebstoffschicht 2 zum Beispiel durch UV-Bestrahlung gleichzeitig von der Trägerplatte 3 entfernt.

Die Trägerplatte 3 wird in dem erfindungsgemäßen Verfahren nicht beschädigt, sie kann für das Aufbringen weiterer Bauelementebenen auf den Bauelementstapel weiter verwendet werden.

## Patentansprüche

1. Verfahren zur Herstellung einer dreidimensionalen Schaltungsanordnung,
- bei dem eine in einer ersten Hauptfläche (11) Bauelemente umfassende Substratscheibe (1) mit der ersten Hauptfläche (11) über eine Klebstoffschicht (2) auf eine Trägerplatte (3) aufgeklebt wird,
- bei dem die Substratscheibe (1) von einer zweiten, der ersten gegenüberliegenden Hauptfläche (12) her gedünnt wird,
- bei dem auf der zweiten Hauptfläche (12) eine Photolackmaske (4) erzeugt wird,
- bei dem die Substratscheibe (1) in einem Ätzprozeß in einzelne Bauelemente (13) vereinzelt wird, die mit der Trägerplatte (3) verbunden sind,
- bei dem nach Entfernen der Photolackmaske (4) auf mindestens einem der einzelnen Bauelemente (13a) mindestens ein weiteres Bauelement (6) angeordnet und mit diesem zu einem Bauelementstapel (13a, 6) fest verbunden wird,

2. Verfahren nach Anspruch 1,
bei dem als weiteres Bauelement (6) ein Stapel aufgebracht wird, der mindestens zwei übereinander gestapelte Bauelemente umfaßt, die fest miteinander verbunden sind.

3. Verfahren nach Anspruch 1 oder 2,
bei dem die Photolackmaske (4) durch Aufschleudern einer Photolackschicht, Belichtung der Photolackschicht mit einer zu den Bauelementen justierten Lithographie und Entwicklung der Photolackschicht erzeugt wird.

4. Verfahren nach einem der Ansprüche 1 bis 3,
bei dem der Ätzprozeß zur Vereinzelung der Substratscheibe (1) naßchemisch durchgeführt wird.

5. Verfahren nach einem der Ansprüche 1 bis 3,
bei dem der Ätzprozeß zur Vereinzelung der Substratscheibe (1) als Plasmaätzprozeß durchgeführt wird.

6. Verfahren nach einem der Ansprüche 1 bis 5,
bei dem der Bauelementstapel (13a, 6) von der Trägerplatte (3) abgelöst wird.

7. Verfahren nach Anspruch 6,
- bei dem die Trägerplatte UV-durchlässig ist,
- bei dem zum Ablösen des Bauelementstapels (13a, 6) von der Trägerplatte (3) die Klebstoffschicht (2) durch UV-Bestrahlung versprödet wird.

8. Verfahren nach Anspruch 7,
bei dem die Trägerplatte (3) aus Quarzglas und die Klebstoffschicht (2) aus Schmelzkleber gebildet werden.

## Claims

1. Method for producing a three-dimensional circuit arrangement,
- in which a substrate wafer (1) which comprises components in a first main surface (11) is bonded by the first main surface (11) via an adhesive layer (2) to a mount (3),
- in which the substrate wafer (1) is thinned from a second main surface (12) which is opposite the first,
- in which a photoresist mask (4) is produced on the second main surface (12),
- in which the substrate wafer (1) is separated in an etching process into individual components (13) which are connected to the mount (3),
- in which, after removal of the photoresist mask (4), at least one further component (6) is arranged on at least one of the individual components (13a) and is firmly connected thereto to form a component stack (13a, 6).

2. Method according to claim 1,
in which, as the further component (6), a stack is fitted which comprises at least two components which are stacked one above the other and are firmly connected to one another.

3. Method according to Claim 1 or 2,
in which the photoresist mask (4) is produced by spin-on deposition of a photoresist layer, exposure of the photoresist layer using lithography which is adjusted to the components, and development of the photoresist layer.

4. Method according to one of Claims 1 to 3,
in which the etching process for separating the substrate wafer (1) is carried out by wet-chemical means.

5. Method according to one of Claims 1 to 3,
in which the etching process for separating the substrate wafer (1) is carried out by a plasma etching process.

6. Method according to one of Claims 1 to 5,
in which the component stack (13a, 6) is separated from the mount (3).

7. Method according to Claim 6,
- in which the mount is UV-permeable,
- in which the adhesive layer (2) is embrittled by UV radiation in order to detach the component stack (13a, 6) from the mount (3).

8. Method according to Claim 7,
in which the mount (3) is formed from quartz glass, and the adhesive layer (2) is formed from fusion adhesive.

## Revendications

1. Procédé de fabrication d'un circuit tridimensionnel,
- dans lequel une plaquette de substrat (1) comprenant des composants dans une première surface principale (11) est collée sur une plaque de support (3), avec la première surface principale (11), par le biais d'une couche de colle (2),
- dans lequel la plaquette de substrat (1) est amincie à partir d'une seconde surface principale (12) opposée à la première,
- dans lequel un masque de laque photosensible (4) est produit sur la seconde surface principale (12),
- dans lequel la plaquette de substrat (1) est individualisée, au cours d'un procédé de gravure, en composants individuels (13) qui sont reliés à la plaque de support (3),
- dans lequel, après le retrait du masque de laque photosensible (4), au moins un composant supplémentaire (6) est placé sur au moins un des composants individuels (13a) et est relié solidement à celui-ci pour former une pile de composants (13a, 6).

2. Procédé selon la revendication 1, dans lequel on ajoute, en tant que composant supplémentaire (6), une pile qui comprend au moins deux composants empilés l'un sur l'autre et reliés solidement l'un à l'autre.

3. Procédé selon l'une des revendications 1 ou 2, dans lequel on produit le masque de laque photosensible (4) en projetant une couche de laque photosensible, en exposant la couche de laque photosensible à la lumière avec une lithographie ajustée par rapport aux composants et en développant la couche de laque photosensible.

4. Procédé selon l'une des revendications 1 à 3, dans lequel le procédé de gravure pour l'individualisation de la plaquette de substrat (1) est exécuté par attaque chimique par voie humide.

5. Procédé selon l'une des revendications 1 à 3, dans lequel le procédé de gravure pour l'individualisation de la plaquette de substrat (1) est exécuté en tant que procédé de gravure au plasma.

6. Procédé selon l'une des revendications 1 à 5, dans lequel la pile de composants (13a, 6) est séparée de la plaque de support (3).

7. Procédé selon la revendication 6,
- dans lequel la plaque de support laisse passer les rayons UV,
- dans lequel, pour détacher la pile de composants (13a, 6) de la plaque de support (3), la couche de colle (2) est fragilisée en étant exposée à une lumière ultraviolette.

8. Procédé selon la revendication 7, dans lequel la plaque de support (3) est formée de verre quartzeux et la couche de colle (2) est formée d'une colle à fusion.
